# EUROPEAN PATENT APPLICATION

(11) **EP 4 633 306 A1**
(43) Date of publication of application: **15.10.2025**
(21) Application number: 24169743.2
(22) Date of filing: 11.04.2024
(51) Int. Cl.: H05K 7/20

(54) **AUTOMOTIVE ELECTRONIC DEVICE**

(71) Applicant: Aptiv Technologies AG, 8200 Schaffhausen (CH)
(72) Inventor: Barus, Lukasz, 8200 Schaffhausen (CH); Misiorny, Jakub, 8200 Schaffhausen (CH); Tyniec, Maciej, 8200 Schaffhausen (CH)
(74) Representative: Manitz Finsterwald Patent- und Rechtsanwaltspartnerschaft mbB

(57) **Abstract**

An automotive electronic device comprises at least one heat generating electronic component, a heat sink, and a heat transfer structure extending between the at least one heat generating electronic component and the heat sink along an extension axis and comprising a first end section in thermal contact with the heat generating electronic component and a second end section in thermal contact with the heat sink, wherein a cross-sectional area of at least one of the first end section and the second end section of the heat transfer structure is smaller than an area covered by the heat generating electronic component.

## Description

### FIELD

The present disclosure relates to an automotive electronic device comprising at least one heat generating electronic component, a heat sink, and a heat transfer structure extending between the at least one heat generating electronic component and the heat sink along an extension axis and comprising a first end section in thermal contact with the heat generating electronic component and a second end section in thermal contact with the heat sink.

### BACKGROUND

Automotive electronic devices are typically used in a vehicle for a plethora of applications, such as for example engine management, entertainment systems, autonomous driving and the like.

During operation, the electronic component generates heat which is transferred from the electronic component via the heat transfer structure to the heat sink from which the heat is dissipated. In common automotive electronic devices, the heat transfer structure has at least about the same size as the electronic component or is even larger than the electronic component and maintains this size at the heat sink to maximize heat dissipation.

However, such kind of large contact area between the electronic component and the heat transfer structure also increases the possibility of unwanted electromagnetic coupling, like capacitive coupling, between the electronic component and the heat transfer structure, thereby inducing undesired high frequency currents, such as radio frequency currents, in the heat transfer structure and/or the heat sink.

These currents are the source of undesired electromagnetic emissions from the automotive electronic device, which may be emitted from the heat sink forming an outer side of the automotive electronic device. The electromagnetic emissions may not only lead to radiated emissions test failures, but also may impair other electronic components.

In order to avoid unwanted electromagnetic emission from the automotive electronic device, an electromagnetic shielding and/or additional contacts-to-ground are typically provided in previous electronic devices. However, these measures impact mechanical vibration profiles, consume precious component area and increase the assembly effort as well as product costs.

It is therefore desired to provide an automotive electronic device with a simple setup and reduced electromagnetic emission.

### SUMMARY

An automotive electronic device with a simple setup and less electromagnetic emission comprises the features of claim 1.

A reduction of electromagnetic emission from an automotive electronic device is achieved on the basis of the idea that an area for electromagnetic coupling between the electronic component and the heat sink is reduced by making a cross-sectional area of the first end section of the heat transfer structure in thermal contact with the electronic component and/or a cross-sectional area of the second end section of the heat transfer structure in thermal contact with the heat sink smaller than the area covered by the heat generating electronic component. By reducing the area in which electromagnetic coupling may occur, the electromagnetic coupling is reduced or at best entirely suppressed. As a consequence, high frequency currents in the heat transfer structure and/or the heat sink are also reduced or at best may even not occur. This ultimately results in a reduction or entire suppression of electromagnetic emission from the automotive electronic device.

Furthermore, as the electromagnetic emission is reduced an additional electromagnetic shielding and/or contacts-to-ground become evitable, thereby allowing for a more simplified setup of the automotive electronic device.

It is noted that, in view of cooling efficiency, the cross-sectional area of the respective end sections of the heat transfer structure is chosen in a manner that still allows for sufficient cooling of the electronic component. In this regard, it has been shown that it is not necessary for the entire heat transfer structure to have at least the same size as the electronic component in order to achieve sufficient cooling of the electronic component. In fact, such large heat transfer structure may be oversized resulting in excessive heat dissipation from the electronic component, thereby overloading the heat sink which may be then incapable of dissipating heat from another electronic component.

In view of the above, the cross-sectional area of at least one of the end sections of the heat transfer structure can be tailored to balance cooling efficiency and electromagnetic emission reduction.

The cross-sectional areas of the end sections and the area covered by the electronic component are defined in this disclosure as the respective areas that are aligned at least substantially perpendicular to the extension axis of the heat transfer structure.

Furthermore, the area covered by the electronic component may correspond to an area obtained by an orthogonal projection of the electronic component onto a plane arranged at least substantially perpendicular to the extension axis of the heat transfer structure, in particular if the electronic component comprises a nonplanar surface topography.

The first end section and the second end section of the heat transfer structure may be respective axial end sections of the heat transfer structure.

Further embodiments are given in the dependent claims, the description and the drawings.

According to one embodiment, a size of the cross-sectional area of the first end section and a size of the cross-sectional area of the second end section of the heat transfer structure may be at least substantially the same. This allows for an easy production of the heat transfer structure.

Alternatively, the size of the cross-sectional area of the first end section of the heat transfer structure and the size of the cross-sectional area of the second end section of the heat transfer structure may be different.

In particular, the first end section of the heat transfer structure being in thermal contact with the heat generating electronic component may be smaller than the second end section in thermal contact with the heat sink. In this case, the electromagnetic coupling is already suppressed between the electronic component and the heat transfer structure.

However, an opposite configuration is also possible in which the second end section of the heat generating structure in thermal contact with the heat sink is smaller than the first end section of the heat generating structure in thermal contact with the electronic component. In this case, the electromagnetic coupling is suppressed between the heat transfer structure and the heat sink.

It is to be noted that by using differently sized end sections, one end section of the heat transfer structure may still have at least about the same size as the electronic component, as long as the other end section has a cross-sectional area that is smaller than the area covered by the electronic component. For example, the first end section of the heat transfer structure may have at least the same cross-sectional size as the electronic component if the second end section of the heat transfer structure has a size that is smaller than the area occupied by the electronic component. This allows for the removal of heat from the entire electronic component, whereas electromagnetic coupling is suppressed between the heat transfer structure and the heat sink. However, it is also possible that the cross-sectional area of the second end section of the heat transfer structure may have at least the same size as the area covered by the electronic component as long as the first end section of the heat transfer structure is dimensioned smaller than the area covered by the electronic component.

Satisfying heat transfer may be achieved if the heat transfer structure is made of a material comprising a thermal conductivity of at least 100 W/(m K), preferably of at least 200 W/(m·K). In particular, the heat transfer structure may be made of a metal material, such as copper, aluminum or an alloy thereof.

It is noted that the heat sink may also comprise a material with a thermal conductivity of at least 100 W/(m K), preferably of at least 200 W/(m·K). In particular, the heat sink may be made of metal material, such as copper, aluminum or an alloy thereof.

For a further enhanced heat dissipation, the heat sink may comprise heat radiation structures, such as for example radiation fins or radiation columns.

According to one embodiment, the heat transfer structure and the heat sink are formed as a single piece. This allows for an easy production thereof and a good heat transfer between the heat transfer structure and the heat sink. Alternatively, the heat transfer structure and the heat sink may be formed as separate parts, in particular the heat sink and the heat transfer structure being in thermal contact with each other, for example by means of a thermal interface material arranged between the heat sink and the heat transfer structure. A separate formation of the heat sink and the heat transfer structure allows for individually tailoring the heat sink and the heat transfer structure to actual demands. In particular, the material chosen for the heat sink and the heat transfer structure may be different.

Generally, the electronic component and the heat transfer structure may also be formed as a single piece. However, if the electronic component and the heat transfer structure are formed as separate pieces, it is desirable that a thermal interface material may be provided between the heat generating electronic component and the first end section of the heat transfer structure.

The thermal interface material may be a dielectric material. The dielectric thermal interface material may have a thermal conductivity of at least 2 W/(m K), preferably of at least 5 W/(m K) and more preferably of more than 10 W/(m K).

The dielectric thermal interface material may comprise a filler material with a thermal conductivity of at least of at least 100 W/(m K), preferably of at least 200 W/(m K) to enhance thermal conduction. In particular, the filler material may comprise at least one selected of metal particles, carbon particles and carbon nano-tubes.

Furthermore, the thermal interface material may also be any other kind of conventional thermal interface material, such as, but not limited to, a thermal paste, a thermal adhesive, a thermal tape or the like.

The thermal interface material may not only be provided between the heat transfer structure and the electronic component, but may also cover other areas of the electronic component not in contact with the heat transfer structure. In order to ensure that the thermal interface material is sufficiently in contact with the electronic component in the areas not in contact with the heat transfer structure, an insulator body may be attached to the first end section of the heat transfer structure, the thermal interface material being provided at least partially between the heat generating electronic component and the insulator body. It is to be noted, that an insulator body may be attached to the second end section of the heat transfer structure in addition or alternatively to the insulator body attached to the first end section of the heat transfer structure. In this case, a thermal interface material may be provided at least partially between the insulator body and the heat sink.

The insulator body may be made of an electrically insulating material and/or an elastically material, such as for example a silicone material or a rubber material.

In particular, by forming the insulator body of an elastically material, the insulator body attached to the first end section of the heat transfer structure may bias the thermal interface material against the electronic component. This ensures that the thermal interface material remains in contact with the electronic component enhancing further heat transfer therefrom.

In a similar manner, the insulator body attached to the second end section of the heat transfer structure may bias the thermal interface material against the heat sink.

Furthermore, by forming the insulator body of an insulating material, electromagnetic coupling can be further reduced.

The insulator body may be securely attached to the first end section of heat transfer structure by being at least partially retained by a recess formed at the first end section of the heat transfer structure. Likewise, the insulator body attached to the second end section of the heat transfer structure may be at least partially retained by a recess formed at the second end section of the heat transfer structure.

The recess may form a shoulder offset inwardly from a side surface of the heat transfer structure, in particular such that the size of the cross-sectional area of the first end section of the heat transfer structure is reduced, preferably to be smaller than the area covered by the electronic component. In this connection, the recess may also extend in an axial direction with regard to the extension axis of the heat transfer structure from a respective end face of at least one of the first end section facing the electronic component and the second end section facing the heat sink. Furthermore, an axial length of the recess may be shorter than an axial length of the remaining heat transfer structure. That is the axial length of the recess is shorter than an axial length of the remaining heat transfer structure without the recess. This reduces electromagnetic coupling, but still allows for sufficient heat transfer away from the electronic component.

The shoulder may act as a counter bearing for the insulator body biasing the thermal interface material against the electronic component. In this regard, the insulator body may have an axial length in direction of the extension axis of the heat transfer structure that is larger than an axial length of the recess in direction of the extension axis of the heat transfer structure. In an assembled state of the automotive electronic device, the elastically insulator body is compressed between the shoulder and the electronic component, thereby biasing the thermal interface material against the electronic component.

The recess may at least partially extend in a circumferential direction of the heat transfer structure.

The insulator body may have a ring like shape. In this regard, the recess may entirely extend in the circumferential direction, such that the ring like shaped insulator body surrounds a recessed portion formed at the first end section of the heat transfer structure, which also securely retains the insulator body at the heat transfer structure.

In this disclosure, a ring like shape may not only refer to a circular ring, but also to any other types of ring shapes, in particular a ring comprising a non-round inner opening and/or comprising a non-round outer circumference. For example, the insulator body may have a polygonal inner opening and/or a polygonal outer circumference.

It is further noted that the recess may also be formed as a groove at least partially extending in circumferential direction of the heat transfer structure. This groove may retain a corresponding protrusion formed at the insulator body.

It is also to be noted that the cross-section of the heat transfer structure may not only be reduced in the region of the recess. Instead, the cross-section of the entire heat transfer structure may be reduced between the electronic component and the heat transfer structure with regard to the area covered by the electronic component. In this connection, the insulator body may entirely axially extend between the electronic component and the heat sink in direction of the extension axis of the heat transfer structure, such that respective axial end sections of the insulator body respectively abut the electronic component and the heat sink. A surface of the heat sink facing the electronic component may then act as a counter bearing for the insulator body. Such a configuration may be used for a flat setup of the automotive electronic device.

In a configuration in which the insulator body entirely axially extends between the electronic component and the heat sink, the insulator body may at least partially surround the heat transfer structure. However, it is also possible that the heat transfer structure at least partially surrounds the insulator body.

The electronic component of the present automotive electronic device may be an integrated circuit or a component of an integrated circuit.

### DRAWINGS

Exemplary embodiments and functions of the present disclosure are described herein in conjunction with the following drawings, showing schematically:
- Fig. 1: a perspective cross-sectional view of a schematic automotive electronic device comprising a heat transfer structure according to a first embodi-ment; and
- Fig. 2: a side view of a heat transfer structure according to a second embodi-ment.

### DETAILED DESCRIPTION

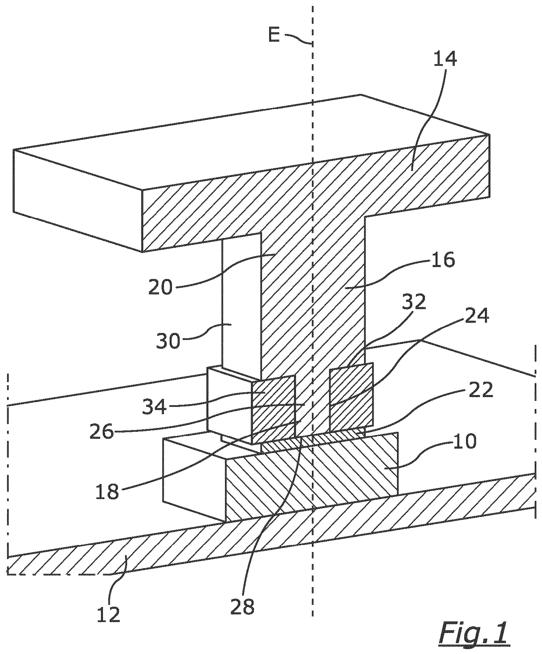

In the drawings, Fig. 1 shows an exemplary automotive electronic device that may be used for various applications, such as for example engine management, entertainment systems, autonomous driving and the like.

The automotive electronic device comprises at least one heat generating electronic component 10, which in the shown embodiment is an integrated circuit disposed on a circuit board 12.

In order to cool the heat generating electronic component 10, the electronic component 10 is thermally connected to a heat sink 14 via a heat transfer structure 16 axially extending between the electronic component 10 and the heat sink 14, the heat transfer structure 16 thereby defining an extension axis E.

In particular, the heat transfer structure 16 comprises a first end section 18 in thermal contact with the electronic component 10 and a second end section 20 in thermal contact with the heat sink 14.

In the present embodiment, the heat transfer structure 16 and the heat sink 14 are in thermal contact as being formed as a single piece, which may be made of a material comprising a thermal conductivity of at least 100 W/(m K), preferably of at least 200 W/(m K). For example, the heat transfer structure 16 and the heat sink 14 may be made of a metal material, such as copper, aluminum or an alloy thereof.

In contrast to that, the heat transfer structure 16 and the electronic component 10 are in thermal contact by means of a thermal interface material 22 arranged between the heat transfer structure 16 and the electronic component 10, namely between the first end section 18 of the heat transfer structure 16 and the electronic component 10.

In the present embodiment the thermal interface material 22 consists of a dielectric material which may have a thermal conductivity of at least 2 W/(m K) and may further comprise a filler material with a thermal conductivity of at least 100 W/(m K) to enhance thermal conductivity of the thermal interface material 22. Exemplary filler materials are one selected of metal particles, carbon particles and carbon nano-tubes.

As becomes apparent from Fig. 1, the first end section of the 18 of the heat transfer structure 16 is smaller than its second end section 20.

Furthermore, the first end section 18 of the heat transfer structure 16 is smaller than the electronic component 10. In fact, a cross-sectional area of the first end section 18 is smaller than an area covered by the electronic component 10.

Such kind of reduced cross-section of the heat transfer structure 16 at its first end section 18 reduces or at best entirely suppresses an electromagnetic coupling between the electronic component 10 and the heat transfer structure 16, which ultimately leads to less or at best no electromagnetic emission from the automotive electronic device. It is to be understood that for the same purpose, the second end section 20 of the heat transfer structure 16 may have a smaller cross-sectional area than the area covered by the electronic component 10 (not shown in the drawings).

A reduced cross-sectional area of the first end section 18 of the heat transfer structure 16 is obtained in the present embodiment by a circumferentially extending recess 24 formed at the first end section 18 of the heat transfer structure 16, which leaves a recessed portion 26. The recessed portion 26 forms the first end section 18 of the heat transfer structure 16 having the reduced cross-sectional area.

The recess 24 axially extends with respect to the extension axis E of the heat transfer structure 16 from an end face 28 of the first end section 18. As can be seen from the drawings, an axial length of the recess 24 is shorter than an axial length of the remaining heat transfer structure 16, which enables sufficient heat transfer and at the same time reduces electromagnetic coupling.

Furthermore, the recess 24 radially extends with respect to the extension axis E of the heat transfer structure 14 from a side surface 30 of the heat transfer structure 16, thereby forming a shoulder 32 offset inwardly from the side surface 30 of the heat transfer structure 16.

The shoulder 32 forms a counter bearing for a ring like shaped insulator body 34, circumferentially surrounding the recessed portion 26 of the first end section 18 of the heat transfer structure 16, such that the insulator body 34 is attached to the first end section 18 of the heat transfer structure 16.

The insulator body 34 is made of an electrically insulating material. Furthermore, the insulator body 34 is made of an elastically material. For example, the insulator body 34 may be made of a silicone material or a rubber material.

The insulator body 34 is designed such that an axial length of the insulator body 34 with regard to the extension axis E of the heat transfer structure 16 is slightly larger than the axial length of the recess 24. This allows for the insulator body 34 to be compressed between the shoulder 32 and the electronic component 10 in an assembled state of the automotive electronic device. The elastic configuration of the insulator body 34 then securely biases the thermal interface material 22 present between the insulator body 34 and the electronic component 10 against the electronic component 10, thereby enhancing further heat removal from the electronic component 10. At the same time, the insulating configuration of the insulator body 34 reduces electromagnetic coupling between the electronic component 10 and the heat transfer structure 16, thereby also reducing electromagnetic emission from the automotive electronic device.

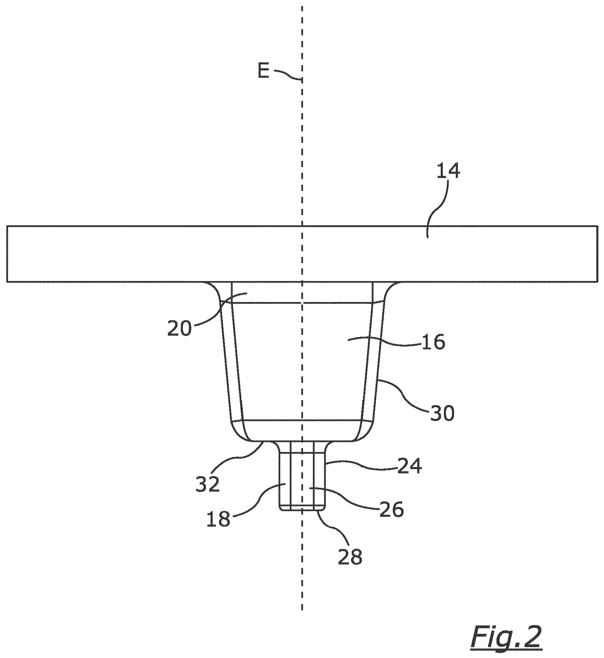

Now, turning to Fig. 2, a second embodiment of a heat transfer structure 16 is described. The heat transfer structure 16 shown in Fig. 2 basically corresponds to the heat transfer structure 16 of Fig. 1, such that the description thereof may also be applied hereto. However, in contrast to the heat transfer structure 14 of Fig. 1, the heat transfer structure 16 of Fig. 2 does not comprise side surfaces 30 basically extending parallel to the extension axis E of the heat transfer structure 16, but which are rather inclined with regard to the extension axis E such that cross-section of the heat transfer structure 16 increases towards its second end section 20, i.e. towards the heat sink 14. Such a configuration allows for an even better heat spreading and also facilitates manufacturing of the heat transfer structure 16.

### Reference numeral list

- 10: electronic component
- 12: circuit board
- 14: heat sink
- 16: heat transfer structure
- 18: first end section
- 20: second end section
- 22: thermal interface material
- 24: recess
- 26: recessed portion
- 28: end face
- 30: side surface
- 32: shoulder
- 34: insulator body

- E: extension axis

## Claims

1. Automotive electronic device comprising:
- at least one heat generating electronic component (10);
- a heat sink (14); and
- a heat transfer structure (16) extending between the at least one heat generating electronic component (10) and the heat sink (14) along an extension axis (E) and comprising a first end section (18) in thermal contact with the heat generating electronic component (10) and a second end section (20) in thermal contact with the heat sink (14);
wherein a cross-sectional area of at least one of the first end section (18) and the second end section (20) of the heat transfer structure (16) is smaller than an area covered by the heat generating electronic component (10).

2. The automotive electronic device according to claim 1,
wherein a size of the cross-sectional area of the first end section (18) of the heat transfer structure (16) and a size of the cross-sectional area of the second end section (20) of the heat transfer structure (16) are different.

3. The automotive electronic device according to claim 1 or 2,
wherein the heat transfer structure (16) and/or the heat sink (14) is made of a material comprising a thermal conductivity of at least 100 W/(m·K), preferably of at least 200 W/(m·K), in particular the heat transfer structure being made of a metal material, such as copper, aluminum or an alloy thereof.

4. The automotive electronic device according to one of the preceding claims, wherein the heat transfer structure (16) and the heat sink (14) are formed as separate parts or as a single piece.

5. The automotive electronic device according to one of the preceding claims, wherein a thermal interface material (22) is provided at least partially between the heat generating electronic component (10) and the first end section (18) of the heat transfer structure (16); and/or
wherein the heat transfer structure (16) and the heat sink (14) are formed as separate parts and wherein a thermal interface material (22) is provided at least partially between the heat sink (14) and the second end section (20) of the heat transfer structure (16).

6. The automotive electronic device according to claim 5,
wherein the thermal interface material is a dielectric material, in particular the dielectric thermal interface material having a thermal conductivity of at least 2 W/(m K), preferably of at least 5 W/(m K) and more preferably of more than 10 W/(m K).

7. The automotive electronic device according to claim 5 or 6,
wherein an insulator body (34) is attached to the first end section (18) of the heat transfer structure (16), the thermal interface material (22) also being provided at least partially between the heat generating electronic component (10) and the insulator body (34); and/or
wherein an insulator body (34) is attached to the second end section (20) of the heat transfer structure (16), the thermal interface material (22) also being provided at least partially between the heat sink (14) and the insulator body (34).

8. The automotive electronic device according to claim 7,
wherein the insulator body (34) is made of an electrically insulating material and/or an elastically material, in particular a silicone material or a rubber material.

9. The automotive electronic device according to claim 7 or 8,
wherein the insulator body (34) attached to the first end section (18) of the heat transfer structure (16) biases the thermal interface material (22) against the electronic component (10); and/or
wherein the insulator body (34) attached to the second end section (20) of the heat transfer structure (16) biases the thermal interface material (22) against the heat sink (14).

10. The automotive electronic device according to one of the claims 7 to 9, wherein the insulator body (34) attached to the first end section (18) of the heat transfer structure (16) is at least partially retained by a recess (24) formed at the first end section (18) of the heat transfer structure (16); and/or wherein the insulator body (34) attached to the second end section (20) of the heat transfer structure (16) is at least partially retained by a recess formed at the second end section (20) of the heat transfer structure (16).

11. The automotive electronic device according to claim 10,
wherein the recess (24) forms a shoulder (32) offset inwardly from a side surface (30) of the heat transfer structure (16), the shoulder (32) acting as a counter bearing for the insulator body (34).

12. The automotive electronic device according to claim 10 or 11,
wherein the recess (24) at least partially extends in a circumferential direction of the heat transfer structure (16).

13. The automotive electronic device according to one of the claims 7 to 12, wherein the insulator body (34) has a ring like shape.

14. The automotive electronic device according to one of the claims 10 to 13, wherein the recess (24) extends in an axial direction with regard to the extension axis (E) of the heat transfer structure (16) from a respective end face (28) of at least one of the first end section (18) facing the electronic component (10) and the second end section (20) facing the heat sink (14).

15. The automotive electronic device according to claim 14,
wherein an axial length of the recess (24) is shorter than an axial length of the remaining heat transfer structure (16).
